# DEMANDE DE BREVET EUROPEEN

(11) **EP 1 069 684 A1**
(43) Date de publication de la demande: **17.01.2001**
(21) Numéro de dépôt: 99870159.3
(22) Date de dépôt: 15.07.1999
(51) Int. Cl.: H03K 17/082

(54) **Procédé et dispositif d'écrêtage actif commande pour convertisseurs de puissance**

(71) Demandeur: Alstom Belgium S.A., 6001 Charleroi (BE)
(72) Inventeur: Monnom, Olivier, B-1435 Mont-Saint-Hubert (BE); Bellavoine, Jacques, B-4520 Vinalmont (BE); Weytens, Michel, B-1420 BRIANE L'ALLEUD (BE)
(74) Mandataire: Van Malderen, Joelle

(57) **Abrégé**

La présente invention se rapporte à un procédé d'écrêtage actif commandé pour un convertisseur de puissance comprenant au moins un interrupteur de puissance associé à un dispositif d'écrêtage à seuil de tension de préférence connecté entre la borne de puissance et la commande dudit interrupteur de puissance, caractérisé en ce que l'on assure le maintien de la tension maximale admissible aux bornes de l'interrupteur de puissance en inhibant la fonction d'écrêtage à seuil de tension lorsque l'interrupteur de puissance est éteint.

La présente invention se rapporte également au dispositif pour la mise en oeuvre de ce procédé.

## Description

### Objet de l'invention

La présente invention concerne un procédé de protection par écrêtage actif des semi-conducteurs des convertisseurs de puissance, dont la commande peut être inhibée en vue de garantir la pleine tension aux bornes des semi-conducteurs.

La présente invention se rapporte également au dispositif pour la mise en oeuvre de ce procédé.

### Arrière-plan technologique et état de la technique

En électronique de puissance, les systèmes de conversion électrique (convertisseurs DC-AC, AC-DC, DC-DC et AC-AC) utilisent des semi-conducteurs commandés faisant office d'interrupteurs électriques, tels que les transistors bipolaires, les thyristors, les GTO, les MOSFET, les IGBT, etc. Ces semi-conducteurs possèdent intrinsèquement une limitation quant à la tension maximale admissible à leurs bornes. Dans certaines circonstances, on souhaite commander l'interrupteur de manière à le rendre conducteur (en le fermant), au moins partiellement, pour éviter qu'une surtension naissante à ses bornes ne vienne à le détruire. C'est pour cette raison que divers circuits de protection ont été développés.

Cette préoccupation apparaît par exemple dans la conception des circuits d'alimentation des moteurs électriques à propulsion (synchrones, asynchrones, continus). Ceux-ci sont constitués de convertisseurs, comme par exemple les onduleurs triphasés, où les semi-conducteurs utilisés en guise d'interrupteurs doivent présenter une tenue en tension au moins équivalente ou même plus importante que la tension caténaire continue nominale (par exemple dans le cas de surtensions de 2 à 3 fois la tension caténaire). Afin de s'assurer une bonne marge de sécurité face à ces surtensions transitoires de la caténaire, on place dans certains cas plusieurs interrupteurs en série, munis éventuellement d'un système d'écrêtage. Ceci est particulièrement vrai dans le cas des IGBT qui autorisent une tenue en tension maximale relativement faible (de l'ordre de 3,3 kV).

Pour les semi-conducteurs permettant un fonctionnement linéaire, comme les MOSFET, les IGBT et les bipolaires, par opposition aux transistors du type thyristors ou GTO qui sont des semi-conducteurs "tout ou rien", on suggère d'utiliser un dispositif particulier dénommé dispositif d'écrêtage actif (traduit en anglais par "active clamping device"). Le principe est simple : on ferme l'interrupteur lorsque la tension à ses bornes dépasse une valeur prédéfinie. A cette fin, un dispositif à seuil de tension (diodes à avalanche Zener, Transil, etc.) est inséré entre une borne de puissance et la commande de l'interrupteur, comme par exemple, entre le collecteur et la grille d'un IGBT.

Ce circuit à seuil de tension réinjecte un courant de commande lorsque la tension aux bornes de l'interrupteur dépasse une valeur prédéfinie (par exemple 2200 V). L'inconvénient est que ce dispositif abaisse le seuil maximal de tension admissible par l'interrupteur lorsque celui-ci ne conduit pas, c'est-à-dire dans le cas où l'interrupteur est ouvert pour un convertisseur à l'arrêt.

Lorsque la tension aux bornes de l'ensemble IGBT - dispositif d'écrêtage actif va dépasser 2,2 kV, il y aura allumage (fermeture) de l'interrupteur de puissance et la tension à ces bornes se maintiendra donc à environ 2,2 kV au lieu de 3,3 kV autorisés comme tension maximale admissible.

Dans ce qui suit, on prend comme exemple des interrupteurs IGBT, généralement préférés aux transistors de puissance bipolaires en vertu de leur plus grande rapidité, tout en gardant à l'esprit que ce qui va suivre s'applique également aux MOSFETs et autres semi-conducteurs capables de fonctionner en régime linéaire.

Le dispositif d'écrêtage actif est donc un dispositif qui sert à protéger l'IGBT contre des surtensions transitoires. Lorsqu'une surtension apparaît, le dispositif d'écrêtage entre en fonction en fermant l'IGBT qui va conduire alors dans sa zone linéaire. Le seuil de tension à partir duquel l'écrêtage entre en fonction est calculé pour que la tension aux bornes de l'IGBT n'atteigne jamais sa tension maximale admissible. Physiquement, le circuit écrêteur est disposé entre le collecteur et la grille d'un l'IGBT de manière à créer une boucle de réaction aussi rapide que possible.

D'un point de vue statique, dans le cas d'un IGBT non commandé, donc d'un IGBT ouvert, la tension maximale que le circuit composé de l'IGBT et du dispositif d'écrêtage actif peut tenir est le seuil d'écrêtage qui est bien moindre que la tension maximale admissible de l'IGBT. Dans l'exemple ci-dessus, l'IGBT possède une tension maximale admissible de 3,3 kV et on lui adjoint un dispositif à écrêtage actif dont le seuil est de 2,2 kV : on obtient ainsi un dispositif qui à l'arrêt, est incontrôlable au-delà de 2,2 kV.

Ceci signifie que d'un point de vue statique, pour rendre au transistor IGBT la tension maximale admissible (soit 3,3 kV dans l'exemple ci-dessus), il est nécessaire de proposer un circuit supplémentaire qui permet d'inhiber l'écrêtage.

### Buts de l'invention

La présente invention vise à proposer un procédé de protection par écrêtage actif commandé d'un convertisseur de puissance alimenté en haute tension, permettant d'inhiber l'écrêtage aux bornes des interrupteurs de puissance lorsque ceux-ci sont ouverts en garantissant ainsi le maintien de la haute tension maximale aux bornes de l'interrupteur.

En outre, la présente invention vise également à proposer un dispositif additionnel permettant aux interrupteurs de tenir la haute tension maximale admissible à leurs bornes lorsqu'ils sont ouverts.

### Principaux éléments caractéristiques de l'invention

La présente invention se rapporte à un procédé de protection contre les surtensions d'un convertisseur de puissance comprenant au moins un interrupteur, de préférence de type IGBT, possédant un dispositif d'écrêtage à seuil de tension connecté entre la borne de puissance et la commande dudit interrupteur, caractérisé en ce qu'en outre, on assure le maintien de la tension maximale admissible aux bornes de l'interrupteur en inhibant la fonction d'écrêtage à seuil de tension dans le cas où l'interrupteur est ouvert.

De manière particulièrement avantageuse, on place un interrupteur d'inhibition entre le dispositif d'écrêtage à seuil de tension et la commande de l'interrupteur de puissance.

Avantageusement, l'interrupteur d'inhibition est commandé par la même commande que l'interrupteur de puissance. Le flanc montant de l'impulsion de commande de l'IGBT d'inhibition est synchronisée sur celui de l'impulsion de commande de l'IGBT de puissance et le flanc descendant de l'impulsion de commande de l'IGBT d'inhibition présente un retard sur celui de l'impulsion de l'IGBT de puissance, ledit retard étant par exemple de l'ordre de 200 µs.

La présente invention se rapporte également à un dispositif pour la mise en oeuvre du procédé décrit ci-dessus.

De manière particulièrement avantageuse, l'interrupteur de puissance est un semi-conducteur à régime linéaire de type IGBT, MOSFET ou bipolaire.

Par contre, l'interrupteur d'inhibition peut être soit un semi-conducteur à régime linéaire, soit un interrupteur "tout ou rien".

Selon une forme d'exécution préférée de l'invention, l'interrupteur de puissance et l'interrupteur d'inhibition sont des IGBT tandis que le dispositif d'écrêtage est constitué principalement par un montage en série d'un nombre suffisant de transils ou diodes Zener pour atteindre la tension d'écrêtage voulue (tension de seuil). L'interrupteur d'inhibition est placé en série avec le dispositif d'écrêtage, l'ensemble étant connecté entre le collecteur (IGBT ou bipolaire) ou le drain (MOSFET) et la grille (IGBT ou MOSFET )ou la base (bipolaire) pour chaque interrupteur de puissance.

Un exemple d'application du circuit d'écrêtage actif est la protection des IGBT de puissance faisant partie d'un circuit hacheur abaisseur de tension comprenant au moins deux IGBT connectés en série.

### Brève description des dessins

La Figure 1 représente le schéma de principe d'un dispositif d'écrêtage actif ou à seuil de tension monté sur un interrupteur de puissance.

La Figure 2 représente le schéma de principe d'un dispositif à IGBT d'inhibition d'écrêtage actif monté entre l'élément à seuil de tension et la commande de l'IGBT de puissance pour la mise en oeuvre du procédé selon l'invention.

La Figure 3 représente les formes d'onde de commande de l'IGBT de puissance et de l'IGBT d'écrêtage.

La Figure 4 représente le schéma de principe complet du circuit d'inhibition d'écrêtage.

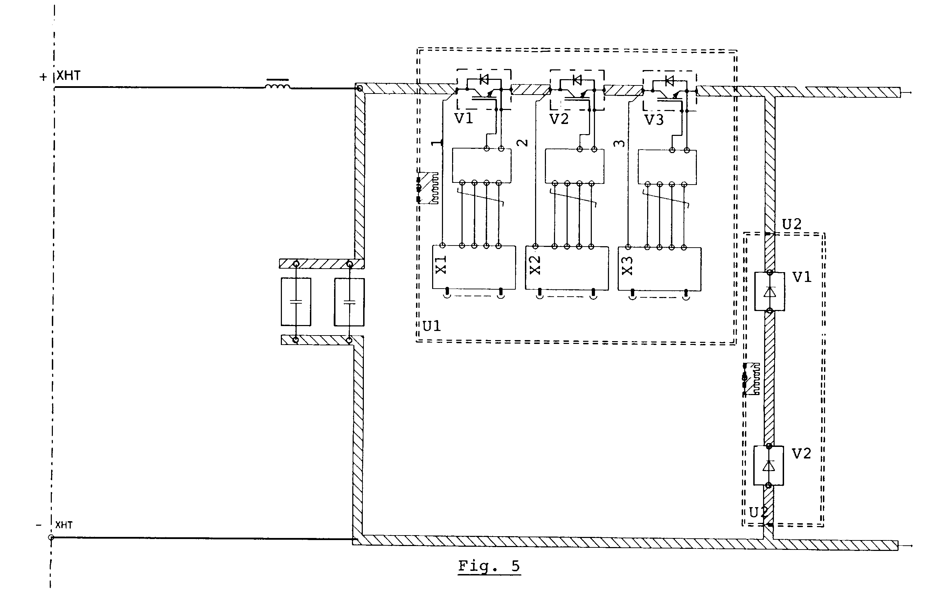

La Figure 5 représente le schéma de principe complet d'un circuit hacheur abaisseur de tension.

### Description détaillée de l'invention

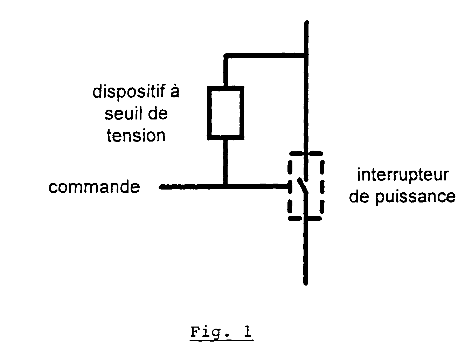

La Figure 1 montre le schéma de principe d'un interrupteur de puissance pourvu d'un dispositif à seuil de tension. Pour inhiber l'écrêtage actif, on insère un second interrupteur dans la boucle d'écrêtage. Cet interrupteur doit pouvoir supporter une forte tension et être rapide. Le choix d'un IGBT en petit boîtier est retenu pour satisfaire à ces critères. Il sera appelé dans la suite interrupteur ou IGBT d'inhibition.

La tension de l'IGBT d'inhibition doit être telle que le système ainsi formé puisse, en statique, récupérer tout ou partie de la tension maximale admissible de l'IGBT de puissance. Si l'on reprend l'exemple d'un IGBT qui a une tension maximale admissible de 3,3 kV et auquel est adjoint un dispositif d'écrêtage actif de 2,2 kV de seuil, la tension maximale admissible de l'IGBT d'inhibition doit valoir au moins 3,3 - 2,2 = 1,1 kV.

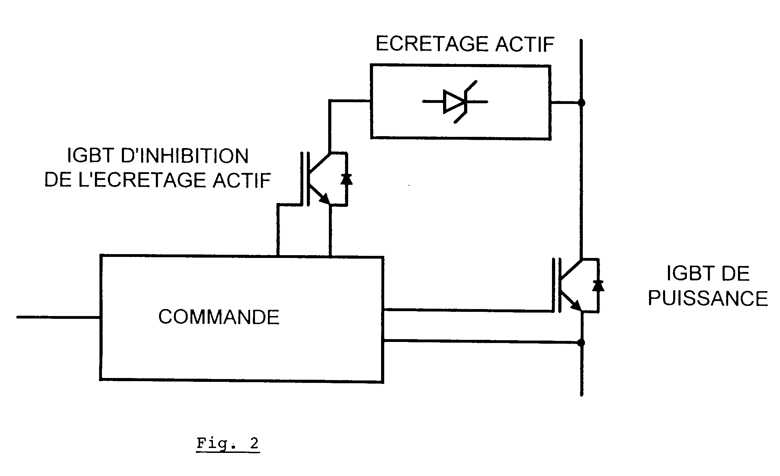

Parmi les nombreuses possibilités de commande de l'IGBT d'inhibition, on en a choisi une qui est dérivée des impulsions de commande de l'IGBT de puissance, ce qui permet de rendre transparent le fonctionnement de l'inhibition d'écrêtage vis à vis de l'électronique de commande. La stratégie de commande de l'IGBT d'inhibition est décrite à la Figure 2. Il faut veiller à ce que l'IGBT d'inhibition soit bien fermé avant l'instant où l'IGBT de puissance entre dans sa zone linéaire, que ce soit à l'allumage ou à l'extinction. Lorsque l'impulsion de commande de l'IGBT de puissance disparaît, on autorise encore l'écrêtage pendant 200 µs environ (Toff).

Le dispositif à écrêtage actif avec son circuit d'inhibition est applicable à tout système de conversion électrique susceptible de subir des surtensions de commutation (hacheur, onduleur, demi-pont redresseur, etc.).

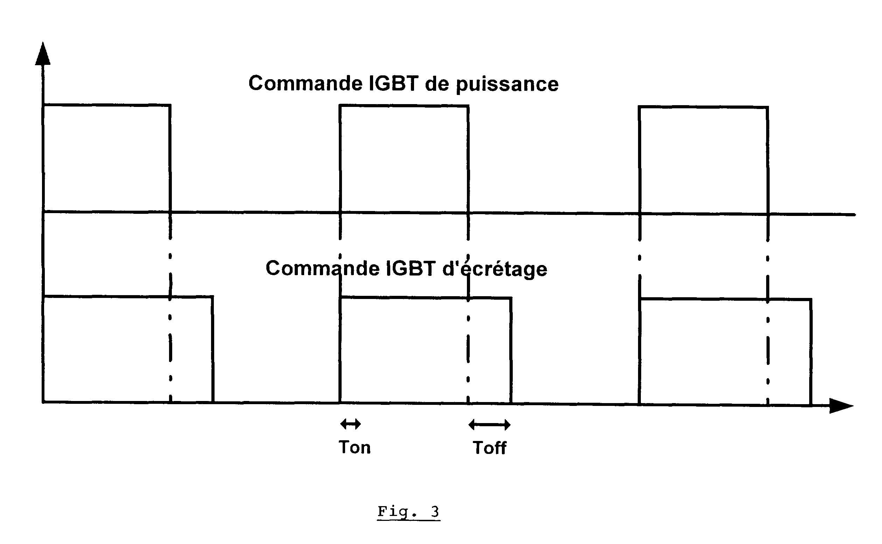

Le schéma complet du circuit d'inhibition d'écrêtage est représenté à la Figure 3, où V29 est l'IGBT d'inhibition, de tension maximale admissible 1,2 kV. Le circuit écrêteur, dont le seuil de tension est de 2,2 kV, est constitué de la diode V34, des résistances R11 et R2, des switchs X14 et X13, des diodes V22 à V1 et de la capacité C1.

Ce circuit reçoit les impulsions de l'IGBT de puissance via la connexion X20 ; il les transforme comme décrit à la Figure 2 et les applique à l'IGBT d'inhibition.

X18 est la connexion qui va à la grille de l'IGBT de puissance (via un circuit auxiliaire) tandis que X1 est relié à son collecteur.

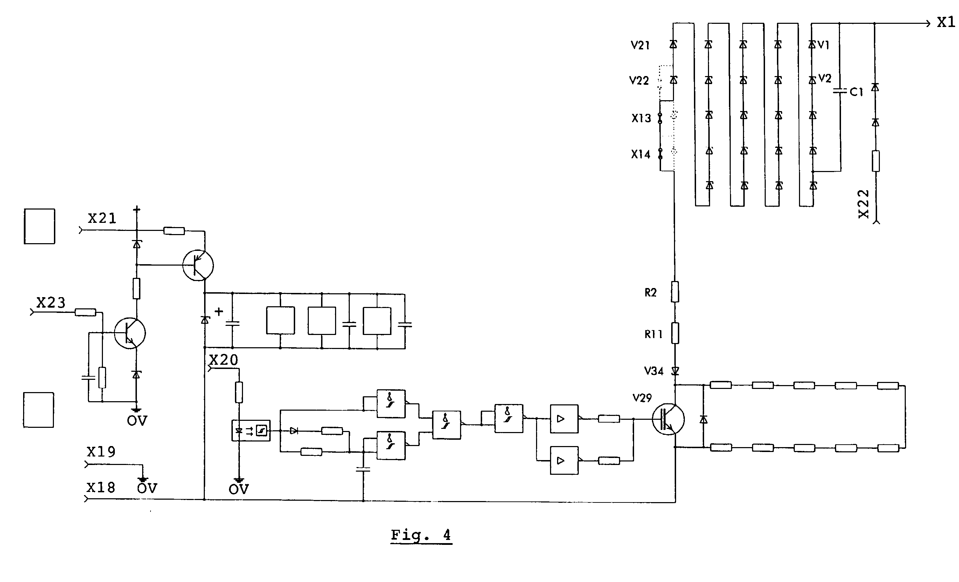

L'exemple particulier présenté ici utilise le dispositif dans le cadre d'une mise en série directe d'interrupteurs de puissance IGBT. La Figure 4 en montre le schéma d'application : il s'agit d'un hacheur dans lequel sont disposés 3 IGBT (U1 : V1, V2, V3) en série ainsi que deux diodes (U2 : V1, V2) en série. Grâce au dispositif d'inhibition d'écrêtage, la tension que peut supporter le hacheur est égale à 3 x la tension maximale admissible à chaque IGBT, soit 3 x 3,3 kV = 9,9 kV. Sans le dispositif d'inhibition d'écrêtage, la tension serait seulement de 3 x 2,2 kV = 6,6 kV, ce qui est insuffisant pour un réseau caténaire classique 3 kV.

## Revendications

1. Procédé d'écrêtage actif commandé pour un convertisseur de puissance comprenant au moins un interrupteur de puissance associé à un dispositif d'écrêtage à seuil de tension de préférence connecté entre la borne de puissance et la commande dudit interrupteur de puissance, caractérisé en ce que l'on assure le maintien de la tension maximale admissible aux bornes de l'interrupteur de puissance en inhibant la fonction d'écrêtage à seuil de tension lorsque l'interrupteur de puissance est éteint.

2. Procédé selon la revendication 1, caractérisé en ce que les moyens permettant d'assurer le maintien de la tension maximale admissible aux bornes de l'interrupteur de puissance sont constitués par un interrupteur d'inhibition placé entre le dispositif d'écrêtage à seuil de tension et la commande de l'interrupteur de puissance.

3. Procédé selon la revendication 1 ou 2, caractérisé en ce que l'interrupteur d'inhibition est commandé par la même commande que l'interrupteur de puissance.

4. Procédé selon la revendication 3, caractérisé en ce que le flanc montant de l'impulsion de commande de l'interrupteur d'inhibition est synchronisée sur celui de l'impulsion de commande de l'interrupteur de puissance et en ce que le flanc descendant de l'impulsion de commande de l'interrupteur d'inhibition présente un retard sur celui de l'impulsion de l'interrupteur de puissance.

5. Procédé selon la revendication 4, caractérisé en ce que ledit retard est compris entre 50 et 500 µs, de préférence proche de 200 µs.

6. Dispositif pour la mise en oeuvre du procédé selon l'une quelconque des revendications précédentes, comprenant un interrupteur de puissance associé à un dispositif d'écrêtage à seuil de tension, de préférence connecté entre la borne de puissance et la commande dudit interrupteur de puissance, caractérisé en ce qu'il comprend un interrupteur d'inhibition placé entre le dispositif d'écrêtage à seuil de tension et la commande de l'interrupteur de puissance.

7. Dispositif selon la revendication 6, caractérisé en ce que l'interrupteur de puissance est un semi-conducteur à régime linéaire tel qu'un IGBT, un MOSFET ou un bipolaire.

8. Dispositif selon la revendication 6 ou 7, caractérisé en ce que l'interrupteur d'inhibition est un semi-conducteur à régime linéaire, de préférence un IGBT, ou un semi-conducteur de type "tout ou rien".

9. Dispositif selon l'une quelconque des revendications 6 à 8, caractérisé en ce que le dispositif d'écrêtage comprend au moins une diode Zener ou transil.

10. Dispositif selon l'une quelconque des revendications 6 à 9, caractérisé en ce que l'interrupteur d'inhibition est placé en série avec le dispositif d'écrêtage, l'ensemble étant connecté entre le collecteur ou le drain et la grille ou la base de l'interrupteur de puissance.

11. Dispositif selon l'une quelconque des revendications 6 à 10, caractérisé en ce que l'IGBT de puissance fait partie d'un circuit hacheur abaisseur de tension comprenant au moins deux IGBT connectés en série.

12. Utilisation du procédé selon l'une quelconque des revendications 1 à 5 ou du dispositif selon l'une quelconque des revendications 6 à 11 pour la protection contre les surtensions pour des interrupteurs de puissance présents dans un circuit hacheur abaisseur de tension.
